# EUROPEAN PATENT APPLICATION

(11) **EP 4 707 926 A1**
(43) Date of publication of application: **11.03.2026**
(21) Application number: 25196428.4
(22) Date of filing: 18.08.2025
(51) Int. Cl.: G03F 7/004, G03F 7/40

(54) **SUBSTRATE TREATING METHOD**

(30) Priority: 06.09.2024 JP 2024154079
(71) Applicant: SCREEN Holdings Co., Ltd., Kyoto-shi, Kyoto 602-8585 (JP); IMEC VZW, 3001 Leuven (BE)
(72) Inventor: TANAKA, Tomoya, 85737 lsmaning (DE); KAWARAZAKI, Hikaru, 85737 lsmaning (DE); NAKANO, Teppei, 85737 lsmaning (DE); FIGUEIREDO DOS SANTOS, Andreia, 85737 Ismaning (DE); CARON, Elke, 85737 Ismaning (DE); ZANDERS, Wesley, 85737 lsmaning (DE); XU, XiuMei, 3001 Leuven (BE)
(74) Representative: Kilian Kilian & Partner mbB

(57) **Abstract**

The present invention relates to a substrate treating method for treating a substrate. The substrate treating method includes a development step, a treatment liquid supply step, a solidified film forming step, and a sublimation step. In the development step, a developer is supplied to a substrate. In the treatment liquid supply step, a treatment liquid is supplied to the substrate. The treatment liquid contains a sublimable substance and a solvent. In the solidified film forming step, the solvent of the treatment liquid evaporates from the treatment liquid on the substrate. In the solidified film forming step, the solidified film is formed on the substrate. The solidified film contains the sublimable substance. In the sublimation step, the solidified film sublimates.

## Description

### BACKGROUND OF THE INVENTION

### 1. TECHNICAL FIELD

The present invention relates to a substrate treating method. The substrate is, for example, a semiconductor wafer, a substrate for liquid crystal display, a substrate for organic electroluminescence (EL), a substrate for flat panel display (FPD), a substrate for optical display, a magnetic disk substrate, an optical disk substrate, a magneto-optical disk substrate, a substrate for photomask, or a solar cell substrate.

### 2. DESCRIPTION OF THE RELATED ART

JP 2021-9988A discloses a substrate treating method for treating substrates. Specifically, the substrate treating method disclosed in JP 2021-9988A includes a treatment liquid supply step, a solidified film forming step, and a sublimation step. In the treatment liquid supply step, a treatment liquid is supplied to a substrate. The treatment liquid contains a solvent and a sublimable substance. In the solidified film forming step, the solvent evaporates, and a solidified film is formed on the substrate. In the sublimation step, the solidified film sublimates. Specifically, the solidified film changes to a gas without being a liquid. The substrate is dried.

Even with the currently-used substrate treating method, the substrate may not be appropriately treated occasionally. For example, even with the currently-used substrate treating method, the substrate may not be appropriately dried occasionally.

The present invention has been made in consideration of the above situation, and its object is to provide a substrate treating method that can appropriately treat a substrate.

### SUMMARY OF THE INVENTION

In order to achieve such an object, the present invention is constituted as stated below. That is, the present invention provides a substrate treating method for treating a substrate, the substrate treating method including a development step of supplying a developer to a substrate; a treatment liquid supply step of supplying a treatment liquid containing a sublimable substance and a solvent to the substrate; a solidified film forming step of forming a solidified film containing the sublimable substance on the substrate by evaporating the solvent from the treatment liquid on the substrate; and a sublimation step of sublimating the solidified film. In other words, the present invention provides a substrate treating method for treating a substrate, the substrate treating method including supplying a developer to a substrate; supplying a treatment liquid containing a sublimable substance and a solvent to the substrate; forming a solidified film containing the sublimable substance on the substrate by evaporating the solvent from the treatment liquid on the substrate; and sublimating the solidified film.

The substrate treating method is for treating a substrate. The substrate treating method includes a development step, a treatment liquid supply step, a solidified film forming step, and a sublimation step. In the development step, a developer is supplied to a substrate. In the treatment liquid supply step, the treatment liquid is supplied to the substrate. The treatment liquid contains a sublimable substance and a solvent. In the solidified film forming step, the solvent evaporates from the treatment liquid on the substrate. In the solidified film forming step, a solidified film is formed on the substrate. The solidified film contains the sublimable substance. In the sublimation step, the solidified film sublimates. The substrate is dried by sublimation of the solidified film.

As described above, the substrate treating method includes a development step. Therefore, according to the present substrate treating method, the substrate can be appropriately treated. Specifically, according to the present substrate treating method, the developer is supplied to the substrate, and then the substrate is appropriately dried.

In the substrate treating method described above, it is preferable that the treatment liquid supply step is performed after the development step, the solidified film forming step is performed after the treatment liquid supply step, and the sublimation step is performed after the solidified film forming step. In other words, it is preferable that the treatment liquid is supplied after supplying the developer, the solidified film is formed after supplying the treatment liquid, and the solidified film is sublimated after forming the solidified film. Therefore, the substrate treating method can appropriately treat the substrate.

In the substrate treating method described above, in the development step, a resist pattern is preferably formed on the substrate. In other words, by supplying the developer, a resist pattern is preferably formed on the substrate. Therefore, in the treatment liquid supply step, the solidified film forming step, and the sublimation step, the substrate has the resist pattern. In the treatment liquid supply step, the treatment liquid is supplied to the substrate having the resist pattern. Even when the substrate has the resist pattern, the substrate is appropriately treated in the treatment liquid supply step, the solidified film forming step, and the sublimation step. For example, in the treatment liquid supply step, the solidified film forming step, and the sublimation step, the substrate is dried while the resist pattern is suitably protected. Rather, when the resist pattern is formed on the substrate in the development step, the present substrate treating method exhibits a remarkable effect.

In the substrate treating method described above, the resist pattern preferably contains metal oxide. Therefore, the substrate is more appropriately treated in the treatment liquid supply step, the solidified film forming step, and the sublimation step. For example, in the treatment liquid supply step, the solidified film forming step, and the sublimation step, the substrate is dried while the resist pattern is more suitably protected.

In the substrate treating method described above, the sublimable substance preferably contains at least one of cyclohexanone oxime and camphor. Therefore, the substrate is appropriately treated in the treatment liquid supply step, the solidified film forming step, and the sublimation step. For example, the substrate is appropriately dried in the treatment liquid supply step, the solidified film forming step, and the sublimation step.

In the substrate treating method described above, the solvent preferably contains isopropyl alcohol. Therefore, the substrate is appropriately treated in the treatment liquid supply step, the solidified film forming step, and the sublimation step. For example, the substrate is appropriately dried in the treatment liquid supply step, the solidified film forming step, and the sublimation step.

The substrate treating method described above preferably includes a replacement step of supplying a replacement liquid to the substrate after the development step and before the treatment liquid supply step. In other words, the substrate treating method preferably includes supplying a replacement liquid to the substrate after supplying the developer and before supplying the treatment liquid. Therefore, in the replacement step, the developer on the substrate is replaced with the replacement liquid. That is, in the replacement step, the developer is removed from the substrate. Therefore, in the treatment liquid supply step, the treatment liquid is appropriately supplied to the substrate.

In the substrate treating method described above, the replacement liquid preferably has a composition identical to a composition of the solvent. Therefore, the replacement liquid has high affinity for the treatment liquid. Accordingly, the treatment liquid is more appropriately supplied to the substrate in the treatment liquid supply step.

The substrate treating method described above preferably includes an exposure step of exposing the substrate before the development step. In other words, the substrate treating method preferably includes exposing the substrate before supplying the developer. Even when the substrate is exposed in the exposure step, the substrate is appropriately treated. Rather, when the substrate treating method includes the exposure step, the present substrate treating method exhibits a remarkable effect.

In the substrate treating method described above, in the exposure step, the substrate is preferably exposed to extreme ultraviolet rays. In other words, by exposing the substrate, the substrate is preferably exposed to extreme ultraviolet rays. Therefore, the substrate is more appropriately treated.

In the substrate treating method described above, in the exposure step, a pattern is preferably transferred to a resist film on the substrate. In other words, by exposing the substrate, a pattern is preferably transferred to a resist film on the substrate. Therefore, it is easy to form the resist pattern on the substrate in the development step. As described above, even when the resist pattern is formed on the substrate in the development step, the substrate is appropriately treated in the treatment liquid supply step, the solidified film forming step, and the sublimation step.

The substrate treating method described above preferably includes a first heating step of heating the substrate after the exposure step and before the development step. In other words, the substrate treating method preferably includes heating the substrate after exposing the substrate and before supplying the developer. Therefore, the substrate is appropriately developed in the development step.

The substrate treating method described above preferably includes a resist film forming step of forming a resist film on the substrate before the exposure step. In other words, the substrate treating method preferably includes forming a resist film on the substrate before exposing the substrate. Even when the resist film is formed on the substrate in the resist film forming step, the substrate is appropriately treated. Rather, when the substrate treating method includes the resist film forming step, the present substrate treating method exhibits a remarkable effect.

In the substrate treating method described above, the resist film preferably contains metal oxide. Therefore, the substrate is more appropriately treated. For example, the substrate is more appropriately dried in the treatment liquid supply step, the solidified film forming step, and the sublimation step.

The substrate treating method described above preferably includes a second heating step of heating the substrate after the resist film forming step and before the exposure step. In other words, the substrate treating method preferably includes heating the substrate after forming the resist film and before exposing the substrate. Therefore, the substrate is more appropriately treated in the exposure step and the development step.

### BRIEF DESCRIPTION OF THE DRAWINGS

For the purpose of illustrating the invention, there are shown in the drawings several forms which are presently preferred, it being understood, however, that the invention is not limited to the precise arrangement and instrumentalities shown.
FIG. 1 is a plan view of an interior of a substrate treating apparatus according to an embodiment;
FIG. 2 is a side view showing a construction of one side of the substrate treating apparatus;
FIG. 3 is a flow chart showing procedures of a substrate treating method;
FIG. 4 is a view schematically showing a substrate in a resist film forming step;
FIG. 5 is a view schematically showing the substrate in an exposure step;
FIG. 6 is a view schematically showing the substrate in a development step;
FIG. 7 is a view schematically showing the substrate in a replacement step;
FIG. 8 is a view schematically showing a part of the substrate in a treatment liquid supply step;
FIG. 9 is a view schematically showing the substrate in a solidified film forming step;
FIG. 10 is a view schematically showing the substrate in the solidified film forming step;
FIG. 11 is a view schematically showing a part of the substrate in a sublimation step;
FIG. 12 is a view schematically showing a part of the substrate in the sublimation step; and
FIG. 13 is a graph showing evaluation of a substrate treated in Example and a substrate treated in Comparative Example.

### DETAILED DESCRIPTION

The following describes a substrate treating method of the present invention with reference to the drawings.

### <1. Outline of Substrate Treating Apparatus>

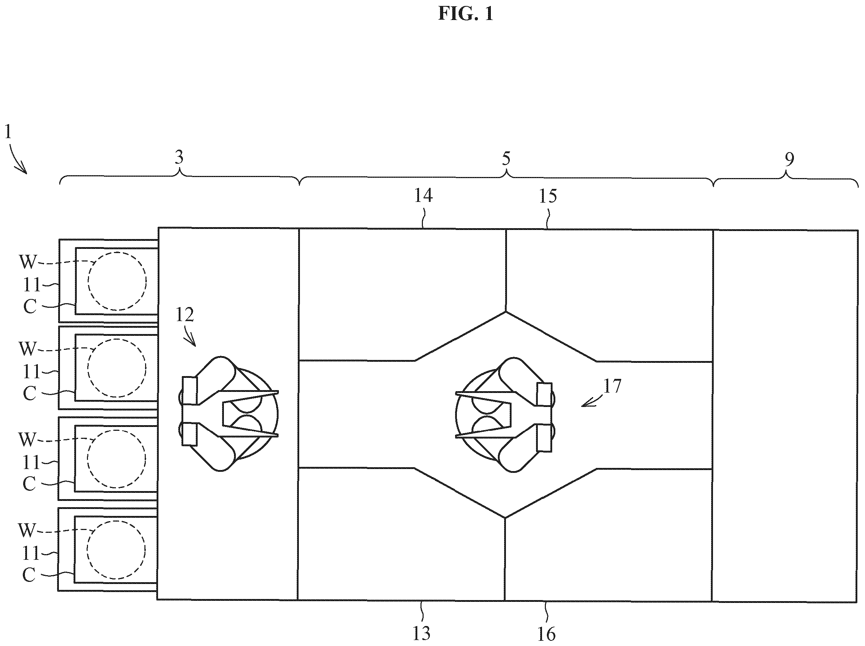

FIG. 1 is a plan view of an interior of a substrate treating apparatus 1 according to an embodiment. The substrate treating apparatus 1 performs treatment on a substrate W. The substrate W is, for example, a semiconductor wafer, a substrate for liquid crystal display, a substrate for organic electroluminescence (EL), a substrate for flat panel display (FPD), a substrate for optical display, a magnetic disk substrate, an optical disk substrate, a magneto-optical disk substrate, a substrate for photomask, or a solar cell substrate. The substrate W has a thin and flat plate shape. The substrate W has a substantially circular shape in plan view.

The substrate treating apparatus 1 includes an indexer 3 and a treatment section 5. The treatment section 5 is disposed on the side of the indexer 3. The treatment section 5 is connected to the indexer 3. The treatment section 5 is connected to an exposure machine 9. The indexer 3 transports the substrate W to the treatment section 5. The treatment section 5 performs treatment on the substrate W. The exposure machine 9 exposes the substrate W. The exposure machine 9 may be an element of the substrate treating apparatus 1. Alternatively, the exposure machine 9 may not be an element of the substrate treating apparatus 1.

The indexer 3 includes a plurality of (e.g., four) carrier platforms 11. The carrier platforms 11 each include one carrier C placed thereon. The carrier C accommodates a plurality of substrates W. The carrier C is, for example, a front opening unified pod (FOUP), a standard mechanical interface (SMIF), or an open cassette (OC).

The indexer 3 includes a transport mechanism 12. The transport mechanism 12 transports the substrate W between the carriers C placed on the carrier platforms 11 and the treatment section 5, respectively. The transport mechanism 12 is, for example, a transport robot.

The treatment section 5 includes a plurality of treating units 13, 14, 15, and 16. The treating units 13 to 16 each perform treatment on the substrate W. For example, the treating unit 13 forms a resist film on the substrate W. The treating unit 14 heats the substrate W. The treating unit 15 heats the substrate W. The treating unit 16 supplies a developer to the substrate W. The treating units 13, 14, 15, 16 are rephrased as treating chambers 13, 14, 15, 16, respectively.

The treatment section 5 includes a transport mechanism 17. The transport mechanism 17 transports the substrate W to the transport mechanism 12. The transport mechanism 17 transports the substrate W to the treating units 13 to 16. Further, the transport mechanism 17 transports the substrate W to the exposure machine 9. The transport mechanism 17 is, for example, a transport robot.

The substrate treating apparatus 1 may further include an interface section (not illustrated). The interface section is disposed between the treatment section 5 and the exposure machine 9. The interface section transports the substrate W between the treatment section 5 and the exposure machine 9.

The following simply describes one example of operation of the substrate treating apparatus 1. The transport mechanism 12 transports the substrate W from the carriers C to the transport mechanism 17.

The transport mechanism 17 transports the substrate W from the transport mechanism 12 to the treating unit 13. The treating unit 13 forms a resist film on the substrate W. The transport mechanism 17 transports the substrate W from the treating unit 13 to the treating unit 14. The treating unit 14 heats the substrate W. The transport mechanism 17 transports the substrate W from the treating unit 14 to the exposure machine 9.

The exposure machine 9 exposes the substrate W.

The transport mechanism 17 transports the substrate W from the exposure machine 9 to the treating unit 15. The treating unit 15 heats the substrate W. The transport mechanism 17 transports the substrate W from the treating unit 15 to the treating unit 16. The treating unit 16 supplies a developer to the substrate W. The transport mechanism 17 transports the substrate W from the treating unit 16 to the transport mechanism 12.

The transport mechanism 12 transports the substrate W from the transport mechanism 17 to the carriers C.

### <2. Construction Example of Treating Unit and Exposure Machine>

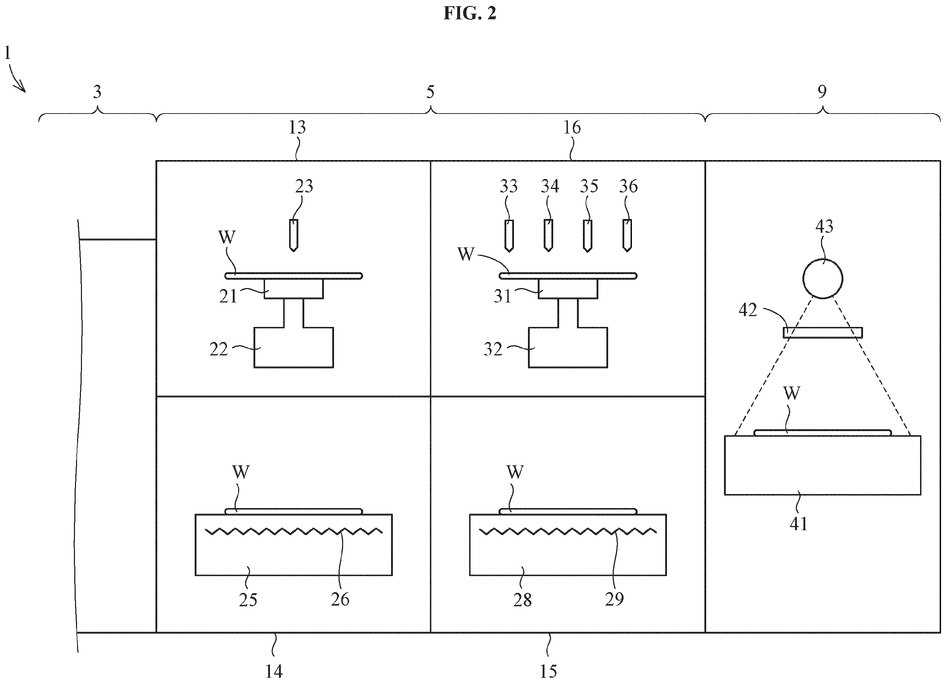

FIG. 2 is a side view showing a construction of one side of the substrate treating apparatus 1. In FIG. 2, the treating units 13 to 16 are arranged on one side of the substrate treating apparatus 1 for convenience. However, the arrangement of the treating units 13 to 16 is appropriately changed.

The treating unit 13 will be described. The treating unit 13 includes a substrate holder 21. The substrate holder 21 holds one substrate W in a substantially horizontal posture.

The treating unit 13 includes a rotation driving unit 22. The rotation driving unit 22 is connected to the substrate holder 21. The rotation driving unit 22 rotates the substrate holder 21. The substrate W held by the substrate holder 21 rotates integrally with the substrate holder 21. The rotation driving unit 22 includes, for example, an electric motor.

The treating unit 13 includes a nozzle 23. The nozzle 23 supplies a resist film material to the substrate W held by the substrate holder 21.

The resist film material supplied by the nozzle 23 will be described. The resist film material is classified as, for example, a negative resist film material.

The resist film material contains metal oxide. The resist film material is also called "metal oxide photoresist". The metal oxide contains, for example, at least one of tin oxide, hafnium oxide, zinc oxide, and zirconium oxide.

For example, the resist film material contains a complex of metal oxide. The complex of metal oxide contains a metal oxide core and ligands. The metal oxide core is bonded to ligands. The metal oxide core is surrounded by ligands. The ligand includes at least one of an organic compound and a resin.

The resist film material contains a solvent. The solvent of the resist film material is, for example, an organic solvent. The solvent of the resist film material contains, for example, at least one of propylene glycol monomethyl ether acetate (PGMEA) and propylene glycol monomethyl ether (PGME).

The treating unit 14 will be described. The treating unit 14 includes a hot plate 25. The hot plate 25 extends in the horizontal direction. The substrate W is placed on the hot plate 25. The hot plate 25 supports one substrate W in a horizontal posture.

The treating unit 14 includes a heater 26. The heater 26 is attached to the hot plate 25. The heater 26 heats the substrate W on the hot plate 25.

The treating unit 15 will be described. The treating unit 15 has a construction similar to the construction of the treating unit 14. The treating unit 15 includes a hot plate 28. The hot plate 28 extends in the horizontal direction. The substrate W is placed on the hot plate 28. The hot plate 28 supports one substrate W in a horizontal posture.

The treating unit 15 includes a heater 29. The heater 29 is attached to the hot plate 28. The heater 29 heats the substrate W on the hot plate 28.

The treating unit 16 will be described. The treating unit 16 includes a substrate holder 31. The substrate holder 31 holds one substrate W in a substantially horizontal posture.

The treating unit 16 includes a rotation driving unit 32. The rotation driving unit 32 is connected to the substrate holder 31. The rotation driving unit 32 rotates the substrate holder 31. The substrate W held by the substrate holder 31 rotates integrally with the substrate holder 31. The rotation driving unit 32 includes, for example, an electric motor.

The treating unit 16 includes nozzles 33, 34, 35, and 36. The nozzle 33 supplies a developer to the substrate W held by the substrate holder 31. The nozzle 34 supplies a replacement liquid to the substrate W held by the substrate holder 31. The nozzle 35 supplies a treatment liquid to the substrate W held by the substrate holder 31. The nozzle 36 supplies a dry gas to the substrate W held by the substrate holder 31.

The developer supplied by the nozzle 33 will be described. The developer is classified, for example, as a solvent developer.

The developer contains, for example, at least one of acetic acid, butyl acetate, 2-heptanone, and propylene glycol monomethyl ether acetate (PGMEA). The developer is, for example, a mixed liquid of propylene glycol monomethyl ether acetate (PGMEA) and acetic acid.

The replacement liquid supplied by the nozzle 34 will be described. The replacement liquid contains, for example, an organic solvent. The replacement liquid contains, for example, an alcohol. The replacement liquid contains, for example, isopropyl alcohol (IPA).

The treatment liquid supplied by the nozzle 35 will be described. The treatment liquid contains a sublimable substance. The sublimable substance has sublimability. "Sublimability" means a property that a single substance, a compound or a mixture changes its phase from a solid phase to a gas phase or from a gas phase to a solid phase without passing through a liquid phase.

The sublimable substance contains, for example, at least one of cyclohexanone oxime and camphor.

The treatment liquid contains a solvent. The solvent of the treatment liquid is, for example, a liquid. The solvent of the treatment liquid dissolves the sublimable substance. The sublimable substance in the treatment liquid is dissolved in the solvent. That is, the treatment liquid contains the solvent and the sublimable substance dissolved in the solvent. The sublimable substance corresponds to a solute of the treatment liquid.

The solvent of the treatment liquid has volatility. The solvent of the treatment liquid can be changed from a liquid to a gas, for example. The solvent of the treatment liquid can evaporate from a liquid.

The solvent of the treatment liquid preferably has a composition identical to a composition of the replacement liquid.

The solvent of the treatment liquid contains, for example, an organic solvent. The solvent of the treatment liquid contains, for example, alcohol. The solvent of the treatment liquid contains, for example, isopropyl alcohol (IPA).

The dry gas supplied by the nozzle 36 will be described. The dry gas is, for example, at least one of air and inert gas. The air is, for example, compressed air. The inert gas is, for example, nitrogen gas. The dry gas preferably has a dew point lower than normal temperatures.

The treating unit 16 performs treatment on the substrate W under an environment of normal pressure. The treatment liquid is used under an environment of normal pressure.

Here, the normal pressure includes standard atmospheric pressure (1 atm, 101325 Pa). The normal pressure falls within a pressure range of 0.7 to 1.3 atm, for example. In this specification, the value of pressure is indicated as absolute pressure relative to absolute vacuum.

The treating unit 16 performs treatment on the substrate W under an environment of normal temperature. The treatment liquid is used under an environment of normal temperatures.

Here, the normal temperatures include a room temperature. The normal temperatures fall within a temperature range of 5°C or more and 35°C or less, for example. The normal temperatures fall within a temperature range of 10°C or more and 30°C or less, for example. The normal temperatures fall within a temperature range of 20°C or more and 25°C or less, for example.

The exposure machine 9 will be described. The exposure machine 9 includes a stage 41. The stage 41 extends in the horizontal direction. The substrate W is placed on the stage 41. The stage 41 supports one substrate W in a horizontal posture.

The exposure machine 9 includes a photomask 42. The photomask 42 is also called a reticle. The photomask 42 is disposed above the stage 41. The photomask 42 has a pattern.

The exposure machine 9 includes a light source 43. The light source 43 is disposed above the photomask 42. The light source 43 emits light. Only the light transmitted through the photomask 42 reaches the substrate W on the stage 41. Thus, the pattern of the photomask 42 is transferred to the substrate W.

The light source 43 emits, for example, extreme ultraviolet rays. In the present specification, extreme ultraviolet rays are appropriately abbreviated as "EUV light". The EUV light has, for example, a wavelength of 13.5 nm.

### <3. Substrate Treating Method>

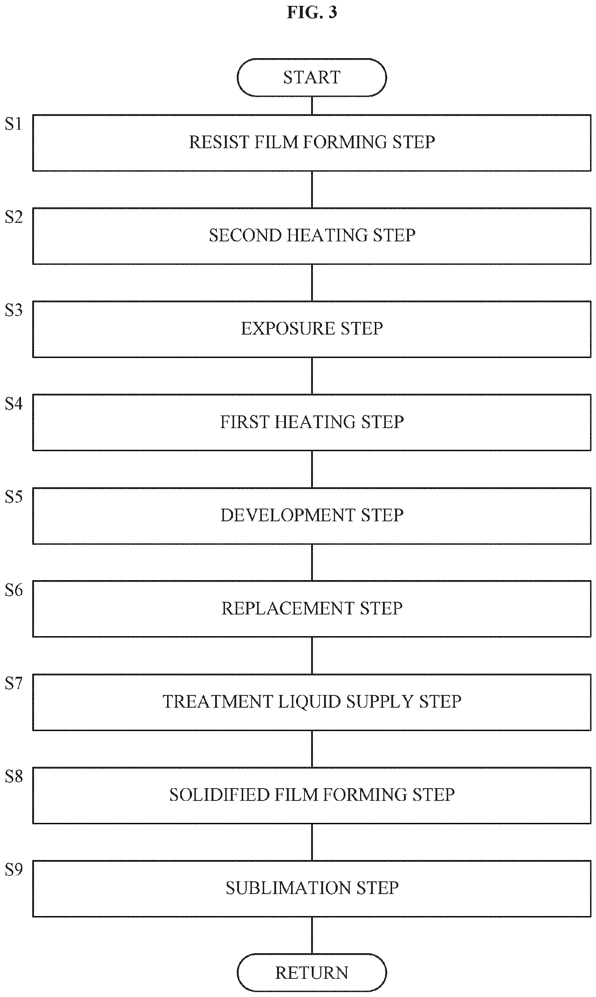

Reference is made to FIGS. 2 to 3. FIG. 3 is a flow chart showing procedures of the substrate treating method. The substrate treating method is for treating the substrate W. The substrate treating method includes a resist film forming step, a second heating step, an exposure step, a first heating step, a development step, a replacement step, a treatment liquid supply step, a solidified film forming step, and a sublimation step.

### <Step S1> Resist film forming step

In the treating unit 13, a resist film is formed on the substrate W.

Specifically, the substrate holder 21 holds the substrate W. The rotation driving unit 22 rotates the substrate W. The nozzle 23 supplies a resist film material to the substrate W. The resist film material contains metal oxide.

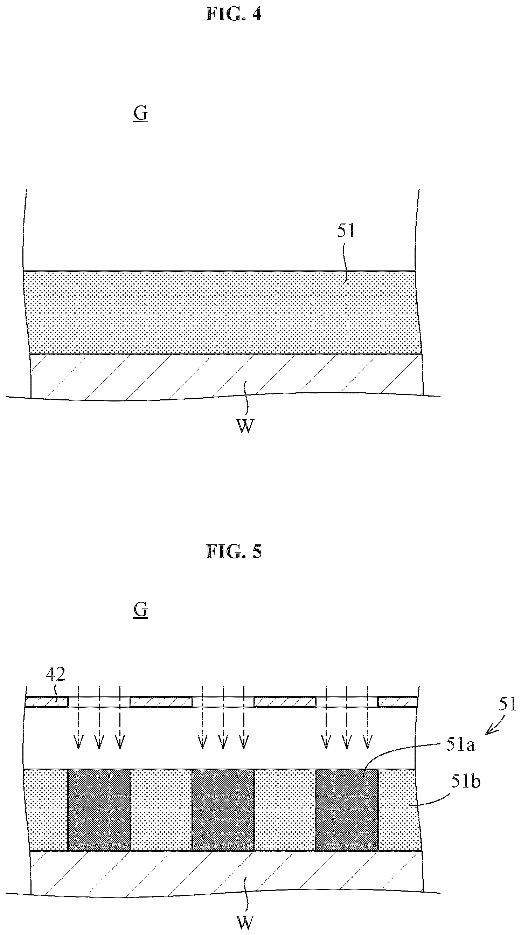

FIG. 4 is a view schematically showing the substrate W in the resist film forming step. A resist film 51 is formed on the substrate W. The resist film 51 is made of a resist film material. For example, the resist film 51 is classified as a negative resist film. The resist film 51 contains metal oxide.

### <Step S2> Second heating step

After the resist film forming step, the second heating step is performed. In the treating unit 14, the substrate W is heated. For example, the substrate W is heated at a temperature between 100°C and 150°C.

Specifically, the substrate W is placed on the hot plate 25. The heater 26 heats the substrate W on the hot plate 25.

In the second heating step, the solvent in the resist film 51 is evaporated. The content of the solvent in the resist film 51 decreases.

### <Step S3> Exposure step

After the second heating step, the exposure step is performed. In the exposure machine 9, the substrate W is exposed. That is, the resist film 51 on the substrate W is exposed.

Specifically, the substrate W is placed on the stage 41. The light source 43 emits light. The pattern of the photomask 42 is transferred to the resist film 51 on the substrate W.

For example, the light source 43 emits EUV light. The substrate W on the stage 41 is exposed to EUV light.

FIG. 5 is a view schematically showing the substrate W in the exposure step. Only the light transmitted through the photomask 42 reaches the substrate W on the stage 41.

For example, before the exposure step, the resist film 51 is soluble in a developer. After the exposure step, the resist film 51 has exposed portions 51a and non-exposed portions 51b. The exposed portion 51a is a portion of the resist film 51 that has been exposed. The exposed portion 51a changes from soluble to insoluble. The non-exposed portion 51b is a portion of the resist film 51 that has not been exposed. The non-exposed portion 51b remains soluble.

More specifically, the resist film 51 contains metal oxide. In the exposed portion 51a, bonds between a metal oxide core and ligands are cut. The metal oxide core and the ligands are separated from each other. Then, the plurality of metal oxide cores are bonded to each other. For example, the plurality of metal oxide cores are condensed with each other. Therefore, the exposed portion 51a changes from soluble to insoluble. In the non-exposed portion 51b, bonds between a metal oxide core and ligands are not cut. Therefore, the non-exposed portion 51b remains soluble.

### <Step S4> First heating step

After the exposure step, the first heating step is performed. In the treating unit 15, the substrate W is heated. For example, the substrate W is heated at a temperature between 130°C and 250°C. For example, the substrate W is heated at a temperature between 180°C and 200°C.

Specifically, the substrate W is placed on the hot plate 28. The heater 29 heats the substrate W on the hot plate 28.

In the first heating step, the insolubility of the exposed portion 51a increases. The exposed portion 51a is further insoluble in the developer.

### <Step S5> Development step

After the first heating step, the development step is performed. In the treating unit 16, the developer is supplied to the substrate W.

Specifically, the substrate holder 31 holds the substrate W. The rotation driving unit 32 rotates the substrate W. The nozzle 33 supplies the developer to the substrate W.

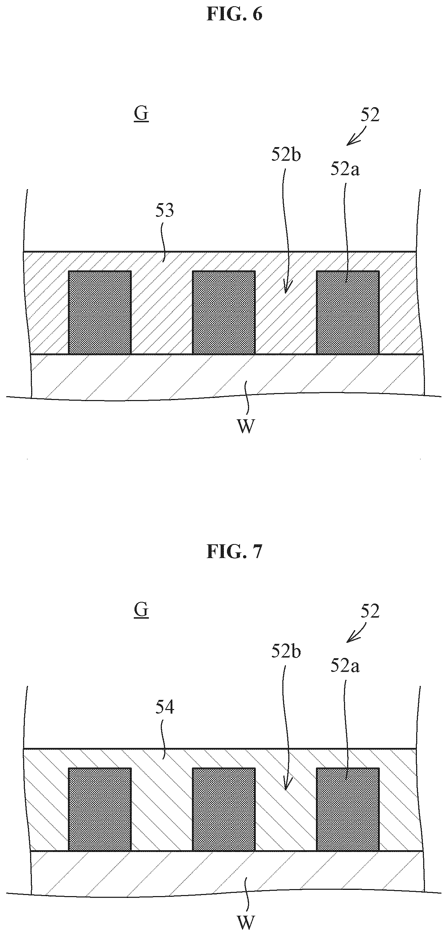

FIG. 6 is a view schematically showing the substrate W in the development step. The developer 53 is supplied to the substrate W. Although the resist film 51 is not illustrated in FIG. 6, the resist film 51 is developed by the developer 53. Specifically, the non-exposed portion 51b is removed from the substrate W by the developer 53. The exposed portion 51a remains on the substrate W.

In the development step, the resist pattern 52 is formed on the substrate W. The resist pattern 52 includes protrusions 52a and a recess 52b. The protrusion 52a includes an exposed portion 51a. The recess 52b is a space. The recess 52b is located at the same position as the non-exposed portion 51b. The recess 52b is formed on the side of the protrusion 52a.

The resist pattern 52 contains metal oxide. The protrusions 52a contain metal oxide.

### <Step S6> Replacement step

After the development step, the replacement step is performed. In the treating unit 16, the replacement liquid is supplied to the substrate W.

Specifically, the substrate holder 31 holds the substrate W. The rotation driving unit 32 rotates the substrate W. The nozzle 34 supplies the replacement liquid to the substrate W. The replacement liquid has, for example, a composition identical to a composition of the solvent of the treatment liquid. The replacement liquid contains, for example, isopropyl alcohol.

FIG. 7 is a view schematically showing the substrate W in the replacement step. The developer 53 on the substrate W is replaced with a replacement liquid 54. The developer 53 is removed from the substrate W.

### <Step S7> Treatment liquid supply step

After the replacement step, the treatment liquid supply step is performed. In the treating unit 16, the treatment liquid is supplied to the substrate W.

Specifically, in the treating unit 16, the substrate holder 31 holds the substrate W. The rotation driving unit 32 rotates the substrate W. The nozzle 35 supplies the treatment liquid to the substrate W. The treatment liquid contains a sublimable substance and a solvent. The sublimable substance contains, for example, at least one of cyclohexanone oxime and camphor. The solvent of the treatment liquid contains isopropyl alcohol.

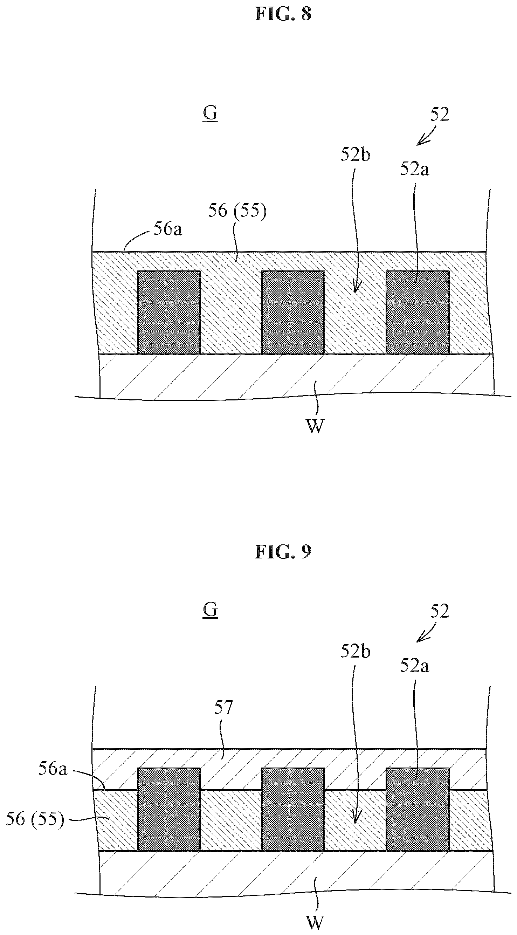

FIG. 8 is a view schematically showing a part of the substrate W in the treatment liquid supply step. The treatment liquid 55 is supplied to the substrate W having the resist pattern 52. The replacement liquid 54 on the substrate W is replaced with the treatment liquid 55. The replacement liquid 54 is removed from the substrate W.

The treatment liquid 55 on the substrate W is referred to as a "liquid film 56". In the treatment liquid supply step, the liquid film 56 is formed. In the treatment liquid supply step, the liquid film 56 covers the substrate W. In the treatment liquid supply step, the liquid film 56 covers the resist pattern 52.

In the treatment liquid supply step, the entire resist pattern 52 is immersed in the liquid film 56. The protrusions 52a are immersed in the liquid film 56. The recess 52b is filled with the liquid film 56.

The liquid film 56 is in contact with a gas G. Specifically, the liquid film 56 has a top face 56a. The top face 56a is in contact with the gas G. The top face 56a corresponds to a gas-liquid interface between the liquid film 56 and the gas G.

In the treatment liquid supply step, the top face 56a is located at a position higher than the resist pattern 52. The resist pattern 52 does not intersect with the top face 56a. The resist pattern 52 does not intersect with the gas-liquid interface between the liquid film 56 and the gas G. Therefore, the resist pattern 52 does not receive the surface tension of the liquid film 56.

In the treatment liquid supply step, the top face 56a is located at a position higher than the protrusions 52a. The protrusions 52a do not intersect with the top face 56a. The protrusions 52a do not intersect with the gas-liquid interface between the liquid film 56 and the gas G. Therefore, the protrusions 52a do not receive the surface tension of the liquid film 56.

### <Step S8> Solidified film forming step

After the treatment liquid supply step, the solidified film forming step is performed. In the treating unit 16, the solvent of the treatment liquid 55 is evaporated from the treatment liquid 55 on the substrate W. A solidified film is formed on the substrate W. The solidified film contains the sublimable substance.

Specifically, the substrate holder 31 holds the substrate W. The rotation driving unit 32 rotates the substrate W.

FIG. 9 is a view schematically showing the substrate W in the solidified film forming step. As described above, the solvent of the treatment liquid 55 has volatility. Therefore, in the solidified film forming step, the solvent in the liquid film 56 is smoothly evaporated.

Eventually, the sublimable substance in the liquid film 56 starts to precipitate on the substrate W. That is, the sublimable substance changes from the solute of the treatment liquid 55 to the solid phase sublimable substance. The solid phase sublimable substance forms a solidified film 57. The liquid film 56 gradually changes to the solidified film 57 due to the precipitation of the sublimable substance.

The solidified film 57 does not contain a solvent. The solidified film 57 is a solid. The solidified film 57 is formed on the substrate W.

For example, the upper portion of the liquid film 56 is first changed to the solidified film 57. For example, before the lower portion of the liquid film 56 is changed to the solidified film 57, the upper portion of the liquid film 56 is changed to the solidified film 57. In this case, the solidified film 57 is located above the liquid film 56. The solidified film 57 covers the top face 56a of the liquid film 56.

When the solidified film 57 entirely covers the top face 56a, the solidified film 57 separates the liquid film 56 from the gas G. The liquid film 56 is not in contact with the gas G. The top face 56a no longer corresponds to a gas-liquid interface. The gas-liquid interface between the liquid film 56 and the gas G disappears.

After the gas-liquid interface between the liquid film 56 and the gas G disappears, the resist pattern 52 does not receive the surface tension of the liquid film 56. After the gas-liquid interface between the liquid film 56 and the gas G disappears, the protrusions 52a do not receive the surface tension of the liquid film 56.

For example, the top face 56a is lowered to the same height position as the resist pattern 52. For example, the top face 56a is lowered to the same height position as the protrusions 52a. In this case, the top face 56a intersects with the resist pattern 52. The top face 56a intersects with the protrusions 52a.

As described above, the top face 56a no longer corresponds to a gas-liquid interface. Therefore, even when the top face 56a intersects with the resist pattern 52, the resist pattern 52 does not receive the surface tension of the liquid film 56. Even when the top face 56a intersects with the protrusions 52a, the protrusions 52a do not receive the surface tension of the liquid film 56. Therefore, the liquid film 56 decreases without applying any significant force on the resist pattern 52. The liquid film 56 decreases without applying any significant force on the protrusions 52a.

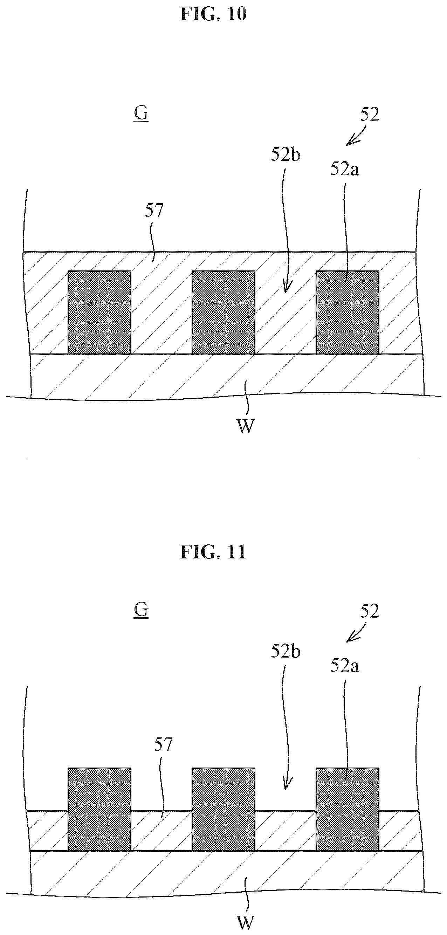

FIG. 10 is a view schematically showing the substrate W in the solidified film forming step. FIG. 10 schematically shows the substrate W when the solidified film forming step completes, for example. The liquid film 56 entirely disappears from the substrate W when the solidified film forming step completes. The liquid film 56 does not remain on the substrate W when the solidified film forming step completes.

When the solidified film forming step completes, only the solidified film 57 exists on the substrate W. The recess 52b is filled with the solidified film 57. The solidified film 57 is in contact with the resist pattern 52. The solidified film 57 supports the resist pattern 52. The solidified film 57 protects the resist pattern 52. For example, the solidified film 57 prevents the resist pattern 52 from collapsing.

The solidified film 57 is in contact with the protrusions 52a. The solidified film 57 supports the protrusions 52a. The solidified film 57 protects the protrusions 52a. For example, the solidified film 57 prevents the protrusions 52a from collapsing.

### <Step S9> Sublimation step

After the solidified film forming step, the sublimation step is performed. In the treating unit 16, the solidified film 57 on the substrate W is sublimated.

Specifically, the substrate holder 31 holds the substrate W. The rotation driving unit 32 rotates the substrate W. The nozzle 36 supplies a dry gas to the substrate W.

The dry gas promotes sublimation of the solidified film 57. The solidified film 57 changes to a gas without being a liquid. The sublimation of the solidified film 57 causes the solidified film 57 to be removed from the substrate W.

FIG. 11 is a view schematically showing a part of the substrate W in the sublimation step. As the solidified film 57 sublimates, the solidified film 57 gradually decreases. The resist pattern 52 starts to be exposed to the gas G. The protrusions 52a start to be exposed to the gas G.

When the solidified film 57 sublimates, the solidified film 57 does not apply any significant force on the resist pattern 52. The solidified film 57 is removed from the substrate W without applying any significant force on the resist pattern 52.

When the solidified film 57 sublimates, the solidified film 57 does not apply any significant force on the protrusions 52a. The solidified film 57 is removed from the substrate W without applying any significant force on the protrusions 52a.

When the solidified film 57 sublimates, the solidified film 57 does not change to a liquid. Accordingly, in the sublimation step, the liquid is not generated on the substrate W. Therefore, in the sublimation step, the gas-liquid interface is not generated in the vicinity of the resist pattern 52. In the sublimation step, the gas-liquid interface is not generated in the vicinity of the protrusions 52a. Therefore, in the sublimation step, the resist pattern 52 does not intersect with the gas-liquid interface. In the sublimation step, the protrusions 52a do not intersect with the gas-liquid interface. Therefore, in the sublimation step, the resist pattern 52 does not receive the surface tension of the liquid. In the sublimation step, the protrusions 52a do not receive the surface tension of the liquid.

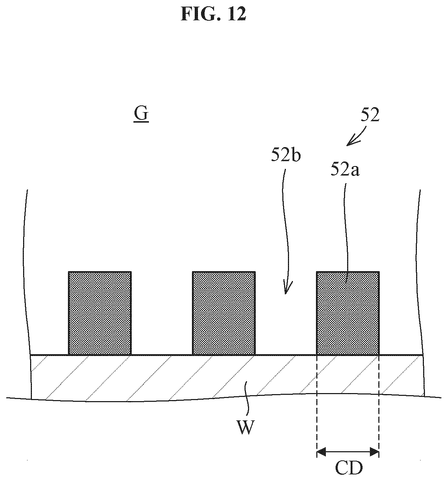

FIG. 12 is a view schematically showing a part of the substrate W in the sublimation step. FIG. 12 schematically shows, for example, the substrate W when the sublimation step completes. The solidified film 57 entirely disappears from the substrate W when the sublimation step completes. The solidified film 57 does not remain on the substrate W when the sublimation step completes. There is no liquid on the substrate W when the sublimation step completes. The substrate W is dried. Specifically, the resist pattern 52 is entirely exposed to the gas G. The protrusions 52a are entirely exposed to the gas G. The recesses 52b are entirely filled with only the gas G.

Here, the resist pattern 52 includes, for example, at least one of a line, a space, a dot, a pillar, and a hole. For example, the resist pattern 52 may be classified into a line-and-space pattern.

The resist pattern 52 has a critical dimension CD. The critical dimension CD is, for example, a width of a line included in the resist pattern 52. The critical dimension CD is, for example, a width of a dot included in the resist pattern 52. The critical dimension CD is, for example, a width of a diameter of a dot included in the resist pattern 52. The critical dimension CD is, for example, a width of a pillar included in the resist pattern 52. The critical dimension CD is, for example, a width of a diameter of a pillar included in the resist pattern 52.

As described above, the treatment liquid 55 is used under an environment of normal temperatures. The treatment liquid 55 is used under an environment of normal pressure.

<4. Technical Meanings of Substrate Treating Method>

The technical meanings of the substrate treating method according to an embodiment will be described with reference to Example and Comparative Example.

The following describes conditions in Example. In Example, a series of treatments shown in FIG. 3 is performed on the substrate W. Specifically, the series of treatments of Example includes a resist film forming step, a second heating step, an exposure step, a first heating step, a development step, a replacement step, a treatment liquid supply step, a solidified film forming step, and a sublimation step. In the resist film forming step, a resist film 51 is formed on the substrate W. The resist film 51 is classified as a negative resist film. The resist film 51 contains metal oxide. In the exposure step, the substrate W is exposed to EUV light. As a result of performing the series of treatments on the substrate W, a substrate W having a resist pattern 52 was obtained. The resist pattern 52 is classified into a line-and-space pattern.

In the exposure step, the plurality of substrates W were exposed with different light amounts. As a result, in Example, a plurality of substrates W having different critical dimensions CD were obtained. The critical dimension CD is a width of a line included in the resist pattern 52.

In general, in a case where the resist film 51 is classified as a negative resist film, the critical dimension CD increases as the amount of light increases.

The following describes conditions in Comparative Example. In Comparative Example, a series of treatments is performed on the substrate W. The series of treatments in Comparative Example includes a spin dry step instead of a replacement step, a treatment liquid supply step, a solidified film forming step, and a sublimation step. Specifically, the series of treatments of Comparative Example includes a resist film forming step, a second heating step, an exposure step, a first heating step, a development step, and a spin dry step. The other conditions in Comparative Example are the same as those in Example.

The substrates W treated in Example and Comparative Example were individually evaluated by defect rate E. The defect rate E is the number of defects per unit length of a line of the resist pattern 52. The unit length is 1 mm.

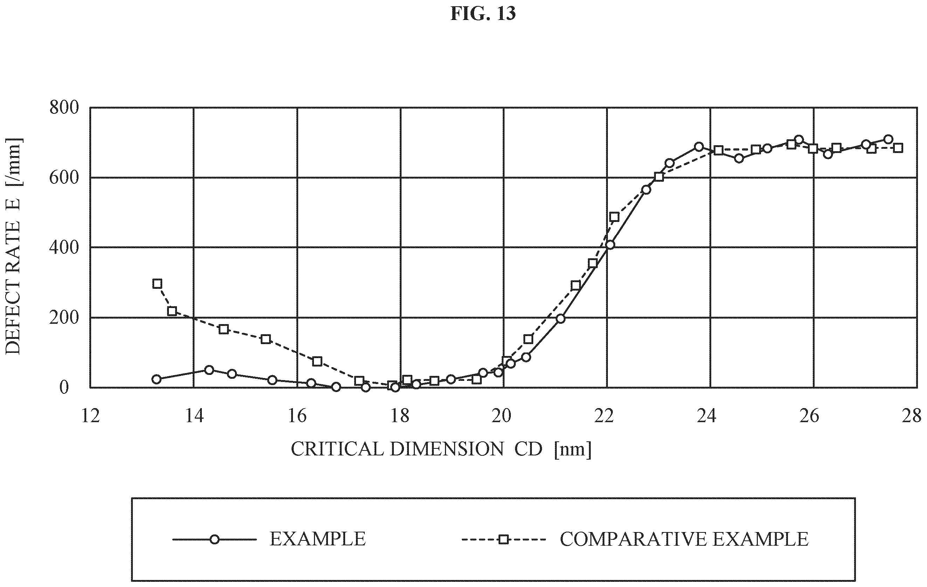

FIG. 13 is a graph showing evaluation of a substrate treated in Example and a substrate treated in Comparative Example. The horizontal axis represents the critical dimension CD. The vertical axis represents the defect rate E. The defect rate E of Example is lower than the defect rate E of Comparative Example. More specifically, when the critical dimension CD is small, the defect rate E of Example is significantly lower than the defect rate E of Comparative Example. When the critical dimension CD is in the range between 12 nm and 18 nm, the defect rate E of Example is significantly lower than the defect rate E of Comparative Example.

The following is found from FIG. 13. The number of defects of the resist pattern 52 in Example is lower than the number of defects of the resist pattern 52 in Comparative Example. Example suppresses collapse of the resist pattern 52 more than Comparative Example. In Example, the resist pattern 52 is suitably protected as compared with that in Comparative Example. In Example, the substrate W is dried while the resist pattern 52 is suitably protected.

### <5. Effect of Embodiment>

The substrate treating method of the embodiment is for treating a substrate. The substrate treating method includes a development step, a treatment liquid supply step, a solidified film forming step, and a sublimation step. In the development step, a developer 53 is supplied to a substrate W. In the treatment liquid supply step, a treatment liquid 55 is supplied to the substrate W. The treatment liquid 55 contains a sublimable substance and a solvent. In the solidified film forming step, the solvent evaporates from the treatment liquid 55 on the substrate W. In the solidified film forming step, a solidified film 57 is formed on the substrate W. The solidified film 57 contains the sublimable substance. In the sublimation step, the solidified film 57 sublimates. The substrate W is dried by sublimation of the solidified film 57.

As described above, the substrate treating method includes the development step. Therefore, according to the substrate treating method, the substrate W can be appropriately treated. Specifically, according to the substrate treating method, the developer 53 is supplied to the substrate W, and then the substrate W is appropriately dried.

After the development step, the treatment liquid supply step is performed. After the treatment liquid supply step, the solidified film forming step is performed. After the solidified film forming step, the sublimation step is performed. Therefore, the substrate treating method can appropriately treat the substrate W.

In the development step, the resist pattern 52 is formed on the substrate W. Therefore, in the treatment liquid supply step, the solidified film forming step, and the sublimation step, the substrate W has the resist pattern 52. In the treatment liquid supply step, the treatment liquid 55 is supplied to the substrate W having the resist pattern 52. Even when the substrate W has the resist pattern 52, the substrate W is appropriately treated in the treatment liquid supply step, the solidified film forming step, and the sublimation step. For example, in the treatment liquid supply step, the solidified film forming step, and the sublimation step, the substrate W is dried while the resist pattern 52 is suitably protected. Rather, when the resist pattern 52 is formed on the substrate W in the development step, the substrate treating method exhibits a remarkable effect.

The resist pattern 52 contains metal oxide. Therefore, the substrate W is more appropriately treated in the treatment liquid supply step, the solidified film forming step, and the sublimation step. For example, in the treatment liquid supply step, the solidified film forming step, and the sublimation step, the substrate W is dried while the resist pattern 52 is more suitably protected.

The sublimable substance contains at least one of cyclohexanone oxime and camphor. Therefore, the substrate W is appropriately treated in the treatment liquid supply step, the solidified film forming step, and the sublimation step. For example, the substrate W is appropriately dried in the treatment liquid supply step, the solidified film forming step, and the sublimation step.

The solvent of the treatment liquid 55 contains isopropyl alcohol. Therefore, the substrate W is appropriately treated in the treatment liquid supply step, the solidified film forming step, and the sublimation step. For example, the substrate W is appropriately dried in the treatment liquid supply step, the solidified film forming step, and the sublimation step.

The substrate treating method includes a replacement step of supplying a replacement liquid 54 to the substrate W. After the development step, the replacement step is performed. The replacement step is performed before the treatment liquid supply step. Therefore, in the replacement step, the developer 53 on the substrate W is replaced with the replacement liquid 54. That is, in the replacement step, the developer 53 is removed from the substrate W. Accordingly, in the treatment liquid supply step, the treatment liquid 55 is appropriately supplied to the substrate W.

As described above, the substrate treating method includes the replacement step. Therefore, after the developer 53 is removed from the substrate W, the treatment liquid 55 is supplied to the substrate W. Accordingly, the treatment liquid 55 does not come into contact with the developer 53. Therefore, the treatment liquid 55 does not react with the developer 53. Accordingly, in the treatment liquid supply step, the treatment liquid 55 is appropriately supplied to the substrate W.

The replacement liquid 54 has a composition identical to a composition of the solvent of the treatment liquid 55. Therefore, the replacement liquid 54 has high affinity for the treatment liquid 55. Accordingly, the treatment liquid 55 is more appropriately supplied to the substrate W in the treatment liquid supply step. For example, it is easy to reduce the consumption of the treatment liquid 55.

The substrate treating method includes an exposure step of exposing the substrate W. The exposure step is performed before the development step. Even when the substrate W is exposed in the exposure step, the substrate W is appropriately treated. Rather, when the substrate treating method includes the exposure step, the substrate treating method exhibits a remarkable effect.

In the exposure step, the substrate W is exposed to extreme ultraviolet rays. Therefore, the substrate W is more appropriately treated.

In the exposure step, a pattern is transferred to a resist film 51 on the substrate W. Therefore, it is easy to form the resist pattern 52 on the substrate W in the development step. As described above, even when the resist pattern 52 is formed on the substrate W in the development step, the substrate W is appropriately treated in the treatment liquid supply step, the solidified film forming step, and the sublimation step.

The substrate treating method includes a first heating step of heating the substrate. After the exposure step, the first heating step is performed. The first heating step is performed before the development step. Therefore, the substrate W is appropriately developed in the development step. For example, after the exposure step, the substrate W includes an exposed portion 51a. The exposed portion 51a is a portion of the substrate W exposed in the exposure step. In the first heating step, for example, the insolubility of the exposed portion 51a in the developer is enhanced. Therefore, the exposed portion 51a appropriately remains on the substrate W in the development step.

The substrate treating method includes a resist film forming step of forming a resist film 51 on the substrate W. The resist film forming step is performed before the exposure step. Even when the resist film 51 is formed on the substrate W in the resist film forming step, the substrate W is appropriately treated. Rather, when the substrate treating method includes the resist film forming step, the substrate treating method exhibits a remarkable effect.

The resist film 51 contains metal oxide. Therefore, the substrate W is more appropriately treated. For example, the substrate W is more appropriately dried in the treatment liquid supply step, the solidified film forming step, and the sublimation step.

The substrate treating method includes a second heating step of heating the substrate. After the resist film forming step, the second heating step is performed. The second heating step is performed before the exposure step. Therefore, the substrate W is more appropriately treated in the exposure step and the development step. For example, the second heating step evaporates the solvent in the resist film 51. Therefore, the resist film 51 is appropriately formed on the substrate W. In other words, the resist film 51 is appropriately modified. Therefore, in the exposure step, the resist film 51 on the substrate W is appropriately exposed. In the development step, the resist film 51 on the substrate W is appropriately developed.

### <6. Modified Embodiment>

The present invention is not limited to the embodiment, and can be modified as follows.
(1) In the substrate treating method of the embodiment, the step performed before the development step may be appropriately changed. For example, at least one of the resist film forming step, the second heating step, the exposure step, and the first heating step may be omitted.
(2) In the substrate treating method of the embodiment, the step performed after the development step may be appropriately changed. For example, the replacement step may be omitted.
(3) In the solidified film forming step, the dry gas may not be supplied to the substrate W.
   Alternatively, in the solidified film forming step, the dry gas may be supplied to the substrate W. In the solidified film forming step, the dry gas may be supplied to the treatment liquid 55 on the substrate W. In the solidified film forming step, the dry gas may be supplied to a liquid film 56. According to the present modified embodiment, in the solidified film forming step, the treatment liquid 55 on the substrate W is exposed to the dry gas. Accordingly, in the solidified film forming step, the solvent in the treatment liquid 55 efficiently evaporates. In the solidified film forming step, the solidified film 57 is efficiently formed on the substrate W.
(4) The embodiment and each of the modified embodiments described in (1) to (3) above may be further varied as appropriate by replacing or combining their constructions with the constructions of the other modified embodiments.

The present invention may be embodied in other specific forms without departing from the spirit or essential attributes thereof and, accordingly, reference should be made to the appended claims, rather than to the foregoing specification, as indicating the scope of the invention.

### Reference Signs List

1: Substrate treating apparatus
5: Treatment section
9: Exposure machine
13: Treating unit (treating unit for resist film forming step)
14: Treating unit (treating unit for second heating step)
15: Treating unit (treating unit for first heating step)
16: Treating unit (treating unit for development step, replacement step, treatment liquid supply step, solidified film forming step, and sublimation step)
51: Resist film
51a: Exposed portion
51b: Non-exposed portion
52: Resist pattern
52a: Protrusion
52b: Recess
53: Developer
54: Replacement liquid
55: Treatment liquid
56: Liquid film
57: Solidified film
CD: Critical dimension
E: Defect rate
W: Substrate

## Claims

1. A substrate treating method for treating a substrate, the substrate treating method comprising:
supplying a developer to a substrate;
supplying a treatment liquid containing a sublimable substance and a solvent to the substrate;
forming a solidified film containing the sublimable substance on the substrate by evaporating the solvent from the treatment liquid on the substrate; and
sublimating the solidified film.

2. The substrate treating method according to claim 1, wherein
by supplying the developer, a resist pattern is formed on the substrate.

3. The substrate treating method according to claim 2, wherein
the resist pattern contains metal oxide.

4. The substrate treating method according to claim 1, wherein
the sublimable substance contains at least one of cyclohexanone oxime and camphor.

5. The substrate treating method according to claim 1, wherein
the solvent contains isopropyl alcohol.

6. The substrate treating method according to claim 1, comprising:
supplying a replacement liquid to the substrate after supplying the developer and before supplying the treatment liquid.

7. The substrate treating method according to claim 6, wherein
the replacement liquid has a composition identical to a composition of the solvent.

8. The substrate treating method according to claim 1, comprising:
exposing the substrate before supplying the developer.

9. The substrate treating method according to claim 8, wherein
by exposing the substrate, the substrate is exposed to extreme ultraviolet rays.

10. The substrate treating method according to claim 8, wherein
by exposing the substrate, a pattern is transferred to a resist film on the substrate.

11. The substrate treating method according to claim 8, comprising:
heating the substrate after exposing the substrate and before supplying the developer.

12. The substrate treating method according to claim 8, comprising:
forming a resist film on the substrate before exposing the substrate.

13. The substrate treating method according to claim 12, wherein
the resist film contains metal oxide.

14. The substrate treating method according to claim 12, comprising:
heating the substrate after forming the resist film and before exposing the substrate.
